# EUROPEAN PATENT SPECIFICATION

(11) **EP 4 283 657 B1**
(45) Date of publication and mention of the grant of the patent: **25.06.2025**
(21) Application number: 21920125.8
(22) Date of filing: 22.01.2021
(51) Int. Cl.: H01J 49/42, H05K 7/20, H01J 49/02

(54) **MASS SPECTROMETER**
MASSENSPEKTROMETER
SPECTROMÈTRE DE MASSE

(43) Date of publication of application: 29.11.2023
(73) Proprietor: HITACHI HIGH-TECH CORPORATION, Tokyo 105-6409 (JP)
(72) Inventor: ISHIGURO, Kouji, Tokyo 105-6409 (JP)
(74) Representative: MERH-IP Matias Erny Reichl Hoffmann Patentanwälte PartG mbB
(86) International application number: PCT/JP2021/002136
(87) International publication number: WO 2022/157905

(56) References cited:
- WO-A1-2014/041862
- WO-A1-2020/213283
- CN-A- 105 703 121
- JP-A- 2014 146 525
- JP-A- 2014 202 664
- JP-A- 2015 192 803
- JP-U- H0 418 960
- JP-U- S6 271 712
- US-A1- 2012 248 305
- US-A1- 2013 015 343
- US-A1- 2013 015 343
- US-A1- 2013 200 260
- US-A1- 2015 206 728

## Description

### Technical Field

The present disclosure relates to a mass spectrometer.

### Background Art

Mass spectrometry has traditionally been used in a variety of fields, for example, measurement of pesticide residues in food through combination with a gas chromatograph, or measurement of endocrine disruptors in the atmosphere through combination with a liquid chromatograph. Due to the recent widespread use of DNA sequencers, structural analysis of proteins generated based on genetic information and of modified proteins in cells has attracted attention, and new findings have begun to be obtained in drug discovery and clinical research.

In addition, mass spectrometric instruments have been used in broader fields, i.e., not only in laboratories in companies and universities but also in clinical laboratories in hospitals, that is, have been used not only by mass spectrometry specialists but also by specialists in other fields. Thus, mass spectrometric instruments are required to have higher handiness and higher durability in addition to high sensitivity as one of the features of mass spectrometry.

The mass spectrometric instrument mainly for quantitative analysis includes a mass spectrometer. The mass spectrometer with internal electrodes having various shapes generates a vacuum within the instrument, and controls and selects ions introduced into the instrument with an electric field. For example, a quadrupole mass spectrometer, also called a Q mass (QMS) or mass filter, includes four cylindrical electrodes. The cylindrical electrodes are assembled with the center of each circle at an apex of a square. Positive and negative DC voltages ±U and positive and negative high-frequency voltages ±V · cos ωt are superimposed on each of adjacent electrodes of the fixed cylindrical electrodes so that voltages of ±U ± V · cos ωt are applied to the electrodes. Charged ions pass through the electrodes while vibrating, and only certain ions pass through the electrodes with stable vibration depending on the voltages and the frequencies. Other ions are increased in vibration while passing through the electrodes and eventually cannot pass through the electrodes due to collisions with the electrodes, for example. A mass spectrum is obtained by linearly changing the high-frequency voltage while keeping the ratio of the DC voltage to the high-frequency voltage constant. To obtain an accurate mass spectrum using the mass spectrometric instrument, it is necessary to prevent drift of a mass axis (sometimes referred to as mass axis) due to changes in measurement environment. For example, to prevent drift of the mass axis when the ambient temperature changes, PTL 1 discloses a mass spectrometric instrument, which is configured to perform feedback control using a detector circuit that detects amplitude of a high-frequency voltage applied to quadrupole electrodes, a circuit for analog-to-digital conversion of output of the detector circuit, and a digital circuit that calculates an error between digitized detection circuit output and an amplitude target value to adjust the amplitude, and uses a heat-generating component, a temperature sensing element, and a temperature control circuit mounted on the control board, on which the detector circuit and/or the analog-to-digital conversion circuit are/is mounted, to make the detector circuit and the analog-to-digital conversion circuit to each have a constant temperature.

### Citation List

### Patent Literature

PTL 1: Japanese Unexamined Patent Application Publication No. 2014-146525

Documents US 2012/248305, US 2013/200260, US 2015/206728 and US 2013/015343 relate to some other exemplary mass spectrometers.

### Summary of Invention

### Technical Problem

In the technique disclosed in PTL 1, however, a temperature-sensing element and a heating element are disposed on the substrate, on which the environmentally sensitive electric elements are disposed, to control ON/OFF of the heating element by substrate temperature, and sufficient consideration is not given for influence on the drift of the mass axis during self-heating when the electric element is energized. Specifically, a high voltage may be applied to a temperature-sensitive electric element. The temperature sensing element for the electric element includes a non-grounded type and a grounded type. In the case of the non-grounded type (for example, a sheath type thermocouple), an electrically insulated temperature sensing element is used, which results in an increase in size and makes it difficult to dispose the electric element on the substrate. In addition, such a temperature sensing element is expensive. On the other hand, in case of using the grounded-type temperature sensing element, the temperature sensing element is disposed with secure electrical insulation between the temperature sensing element and the electric element. In this case, the substrate is typically made of a material with low electrical conductivity, such as resin, and when temperature is measured to control the calorific value of the heating element disposed on the substrate with the measurement result, relatively long response time is taken, and temperature overshoot may occur even if PID adjustment is performed so that the mass axis drift amount does not fall below specification. In particular, in case of a small allowable drift amount of the mass axis, the heating method is difficult to satisfy the specification. In addition, the amount of mass axis drift changes depending on a fixation location of the grounded-type temperature sensing element, and the optimum fixing location must be determined through experiments.

In general, electric elements each have a shorter life with an increase in temperature. For example, life of an aluminum electrolytic capacitor is approximately halved with an increase in temperature of 10°C. The heating method as in PTL 1 therefore leads to shorter life of the electric element and a shorter replacement period of the control board, resulting in an increase in maintenance time and in operation cost.

Further, in the technique disclosed in PTL 1, although a countermeasure is taken for drift of the mass axis when the ambient temperature changes, no consideration is given to drift of the mass axis due to humidity change.

In view of such circumstances, the present disclosure provides a technique to reduce influence of not only environmental temperature but also environmental humidity and thus prevent shortening of life of each electric element forming a power supply of a mass spectrometric instrument.

### Solution to Problem

To solve the above problem, the present disclosure provides a mass spectrometric instrument including a circuit board on which electric elements are disposed, a gas supply unit, and a mechanism that controls humidity and temperature of gas supplied from the gas supply unit, and applies the gas with the humidity and temperature controlled to at least part of the circuit board.

Further features concerning the disclosure will be clarified from the content of this description and the accompanying drawings. The embodiment of the disclosure is achieved by elements and combinations of various elements, and the following detailed description and aspects of the accompanying claims.

The content of this description merely shows typical examples and is not intended to limit the claims or application examples of the disclosure in any sense.

### Advantageous Effects of Invention

According to the technique of the disclosure, it is possible to reduce influence of not only environmental temperature but also environmental humidity and thus prevent shortening of life of each electric element forming a power supply of a mass spectrometric instrument.

### Brief Description of Drawings

Fig. 1 illustrates a change in mass spectrum due to a difference in humidity of environment in which a power supply control unit, which supplies power to a mass spectrometer of a mass spectrometric instrument, is provided.
Fig. 2 illustrates an exemplary schematic configuration of a mass spectrometric instrument 1 according to a present embodiment.
Fig. 3 illustrates an exemplary internal configuration of a power supply control unit 10 according to the embodiment.
Fig. 4 illustrates an exemplary schematic configuration of a closed container 101 according to the embodiment.
Fig. 5 illustrates an exemplary structure (as viewed from directly above) of a connecting portion 1061 between each closed container 101 and a piping unit 106.
Fig. 6 illustrates an exemplary structure (cross section) of the connecting portion 1061 between the closed container 101 and the piping unit 106.

### Description of Embodiments

Hereinafter, one embodiment of the present disclosure will be described with reference to the accompanying drawings. In the drawings, functionally identical elements may be represented by the same numerals. Although the drawings show specific embodiment and implementation examples in accordance with the principles of the disclosure, they are for the understanding of the disclosure and are by no means to be used to interpret the disclosure in a restrictive manner.

Although the embodiment has been described in sufficient detail to enable those skilled in the art to practice the disclosure, it should be understood that other implementations and configurations are possible, and that changes in structure and substitution of various elements are possible without departing from the scope of the technical idea of the present disclosure, as long as said changes fall within the scope of the invention, which is defined by the appended claims.

### Drift of Mass Axis

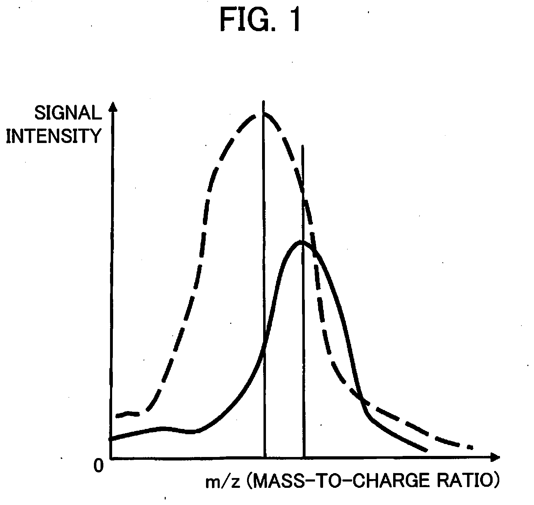

In a mass spectrum measured by the mass spectrometer, drift of a mass axis, change in signal intensity, and degradation of resolution occur depending on the environment (in particular, humidity and temperature) in which the mass spectrometric instrument is provided. Fig. 1 illustrates a change in mass spectrum due to differences in temperature and humidity of the environment where a power supply control unit, which supplies power to the mass spectrometer of the mass spectrometric instrument, is provided. In Fig. 1, the solid line and the dotted line represent mass spectra of the same sample measured at different temperatures and humidities of the environment in which the power supply control unit is provided. As illustrated in Fig. 1, the mass axis (the axis of the maximum signal intensity) drifts due to differences in temperature and humidity, resulting in a difference in signal intensity. The main cause of such phenomena is that, for example, an electric element (capacitor, diode, etc.) used in an electric circuit that feeds back a high-frequency voltage supplied to a Q rod (quadrupole) is affected by temperature and/or humidity, resulting in changes in electrical characteristics. For example, if a capacitor is in a humid environment, a water film will adhere to a surface of the capacitor. This changes capacitance of the capacitor, and changes a dividing ratio of voltage supplied to the quadrupole, and thus the high-frequency voltage cannot be accurately fed back.

This embodiment will now be described on a configuration and a method, which makes electric characteristics of the electric element to be unchanged by a change in temperature and a change (increase) in humidity of an environment in which the electronic element is provided.

### Exemplary Basic Configuration of Mass Spectrometric Instrument

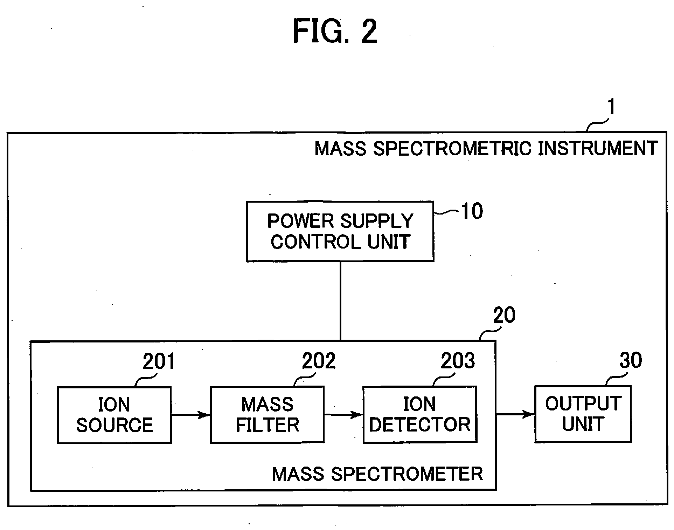

Fig. 2 illustrates an exemplary schematic configuration of a mass spectrometric instrument 1 according to this embodiment. As illustrated in Fig. 2, the mass spectrometric instrument 1 includes a power supply control unit 10, a mass spectrometer 20, and an output unit 30. The power supply control unit 10 supplies power (high-frequency voltage) to a mass filter (quadrupole) 202 of the mass spectrometer 20 at a predetermined voltage dividing ratio. The mass spectrometer 20 includes an ion source 201 that ionizes a sample to be analyzed and supplies it to the mass filter 202, the mass filter 202 that selects ions having a specific m/z ratio among the ions supplied from the ion source 201, and an ion detector 203 that detects the ions selected by the mass filter 202 and measures signal intensity. The output unit 30 includes, for example, a display and a printer, and outputs (displays, prints, or the like) the signal intensity corresponding to the specific m/z ratio measured by the ion detector 203.

Although the quadrupole filter is used as an example of the mass filter 202 in this embodiment, the mass filter 202 may be a hexapole filter, an octupole filter, or a multipole filter.

### Internal Configuration of Power Supply Control Unit

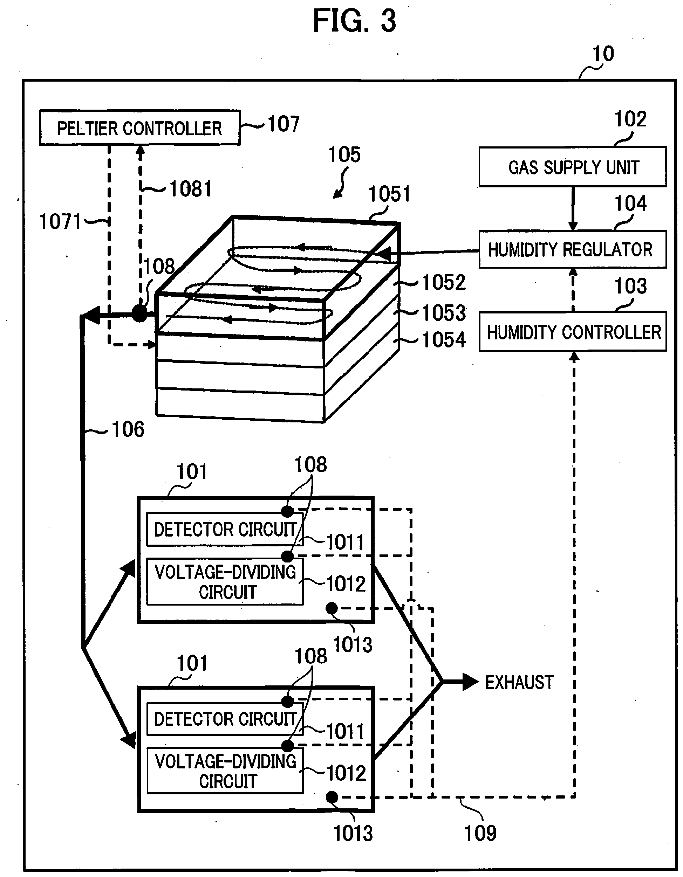

Fig. 3 illustrates an exemplary internal configuration of the power supply control unit 10 according to this embodiment. As illustrated in Fig. 3, the power supply control unit 10 includes: a plurality of closed containers (closed containers for mass filters) 101 holding, for example, electric elements; a gas supply unit 102; a humidity controller 103 that receives information on humidity in each closed container 101 and notifies a humidity regulator of humidity adjustment amount; the humidity regulator 104; a gas cooling unit 105; a piping unit 106 to supply gas output from the gas cooling unit 105 to each closed container 101; a Peltier controller 107 that determines gas temperature; and a temperature measuring unit 108 that measures temperature of the gas to be supplied and notifies the Peltier controller 107 of the gas temperature.

Each of the closed containers 101 has a heat-insulating structure, and includes a circuit board, on which electric elements such as a detector circuit 1011 including a diode and a voltage-dividing circuit 1012 including a capacitor are mounted, and a humidity/temperature measuring instrument 1013 that measures humidity and temperature in the closed container 101 and notifies the humidity controller 103 of the humidity and the temperature.

The gas supply unit 102 generates gas (for example, nitrogen gas) to be cooled and supplied to each closed container 101, and supplies the gas to the humidity regulator 104.

The humidity controller 103 determines humidity regulation amount based on the information on the humidity and temperature in each closed container 101 received from the humidity/temperature measuring instrument 1013. Alternatively, the humidity controller 103 determines the humidity regulation amount on the basis of information on the humidity in each closed container 101 received from the humidity/temperature measuring instrument 1013 and the temperature information received from the temperature measuring units 108 on the detector circuit 1011 and the voltage-dividing circuit 1012. Specifically, the humidity controller 103 uses the information on the humidity and the temperature in each closed container 101 received from the humidity/temperature measuring instrument 1013 to calculate (for example, using a known dew point temperature calculation formula) dew point temperature T1 of the space in the closed container 101 in which the circuit board with the electric element mounted thereon is disposed (since the amount of saturated water vapor is known from the temperature, the dew point temperature T1 in the closed container 101 can be calculated) . The humidity controller 103 determines humidity of the gas having a dew point T2 smaller than the calculated dew point temperature T1 (T2 < T1), and notifies the humidity regulator 104 of the humidity of the gas. The reason why T2 < T1 is determined is because dew condensation due to applied gas can be prevented by applying a gas having a dew point lower than that of the environment (humidity) in the closed container 101. This can prevent mass axis drift due to formation of a water film on the surface of the capacitor or the like. During operation of the instrument, temperatures of the detection circuit 1011 and the voltage dividing circuit 1012 each rise due to heat generated by the electric elements in the circuit board. Temperature of each circuit board including the electric elements is different from the temperature measured by the humidity/temperature measuring instrument 1013. To control the humidity more accurately, therefore, the humidity controller 103 uses temperatures measured by the temperature measuring units 108 on the detector circuit 1011 and the voltage-dividing circuit 1012 to calculate the dew point temperature T1. In case of a plurality of the closed containers 101, average temperature of the closed containers 101 may be obtained (since the closed containers are located in the instrument, temperature difference between them is only about several degrees Celsius) to obtain the dew point T1. If T2 is sufficiently smaller than T1 (e.g., 1/10), no dew condensation occurs.

The humidity regulator 104 regulates humidity of the gas supplied from the gas supply unit 102 (regulates such that the supplied gas has a dew point T2) on the basis of the humidity information (or information on the humidity regulation amount) received from the humidity controller 103, and supplies the humidity-adjusted gas to the gas cooling unit 105 (specifically, a metal plate 1051 having a cooling ventilation channel as described later). Nitrogen gas (N₂) controlled to have a dew point of -40°C (very low humidity) and a humidity of 0.1% or less can be supplied to the gas cooling unit 105.

The gas cooling unit 105 has a metal plate 1051 having the cooling ventilation channel, a Peltier cooling (or heating) unit 1052 with an output of several tens of watts, a heat sink 1053 made of a heat-transferable metal, and a cooling fan 1054 to remove heat (for heat removal). The gas cooling unit 105 controls temperature and a flow rate of the gas supplied via the humidity regulator 104 and discharges the gas to a piping unit 106 connected to each closed container 101 (at a flow rate of 10L/min, for example).

The temperature measuring unit 108 includes, for example, a thermocouple, and measures temperature of the gas discharged from the ventilation channel of the metal plate 1051 at any given timing (either periodically or in a constantly monitored manner) and notifies the Peltier controller 107 of the measurement result (temperature) .

The Peltier controller 107 controls an energizing current value for a Peltier element (Peltier cooling unit) 1052 such that temperature of the gas discharged from the ventilation channel reaches the desired temperature (e.g., 18 ± 0.5°C), based on the temperature notified from the temperature measuring unit 108.

The piping unit 106 can be formed by, for example, covering the periphery of a nylon tube with a heat insulating material (e.g., wool material). In detail, the piping unit 106 is formed by cutting a hollow cylindrical heat insulating material made of a foammaterial, wrapping the material around the outer periphery of the pipe, and fixing the material. A heat insulating material is disposed on the outer surface of the metal plate 1051 having the cooling ventilation channel. The heat insulating material is formed of a resin plate with a low electrical conductivity and an air layer (which has the lowest thermal conductivity and becomes a good heat insulating material by suppressing air flow). The output of the Peltier element can be minimized because heat input from the periphery of the metal plate having the cooling ventilation channel is reduced as much as possible.

Temperature of the nitrogen gas is thus controlled by the Peltier cooling unit 1052 including the Peltier element, and the nitrogen gas is blown onto the circuit board (including the detection circuit 1011 and the voltage-dividing circuit 1012) housed in the closed container 101. As described above, the nitrogen gas is controlled at, for example, 18°C ± 0.5°C and blown into the closed container 101 for the mass filter, thereby temperature around each electric element within the closed container 101 can be controlled constant, and the electric element can be forcibly air-cooled. As a result, it is possible to reduce a temperature rise value due to self-heating of the electric element, and decrease the drift amount of the mass axis to the allowable value or lower, thereby minimize influence of the environment and reduce the drift amount of the mass axis.

### Closed Container 101

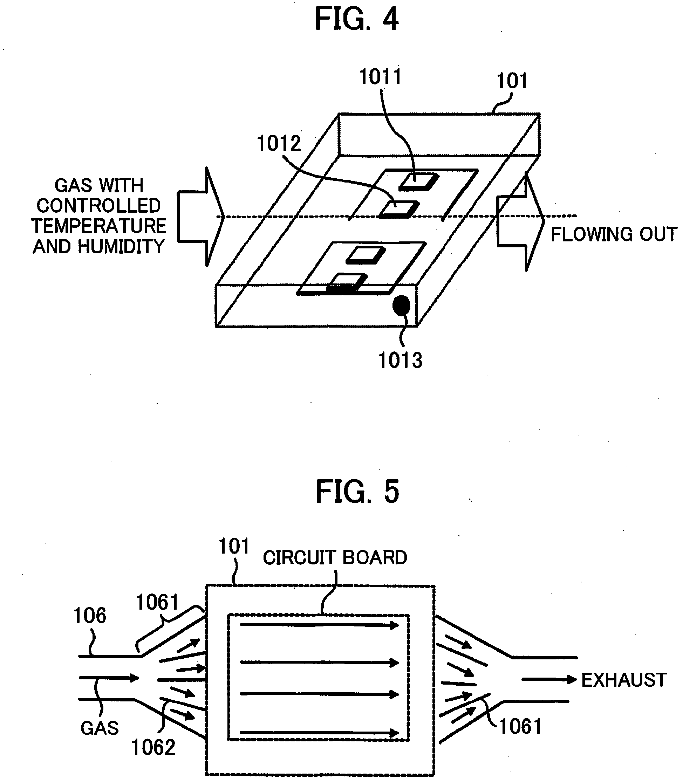

Fig. 4 illustrates an exemplary schematic configuration of the closed container 101 according to this embodiment. As illustrated in Fig. 4, the closed container 101 has, in a sealing casing having the heat-insulating structure: a circuit board, on which the detector circuit (that can be formed of a diode) 1011 and the voltage-dividing circuit (that can be formed of a capacitor) 1012 are mounted; and the humidity/temperature measuring instrument 1013 to measure humidity and temperature in the sealing casing. In addition, the closed container 101 has an inlet and an outlet for nitrogen gas, and has a guide unit for uniformly applying the gas to the circuit board in a space between the inlet and the outlet.

The electric element, such as a capacitor and a diode, has a temperature limiting point of 80 ° C. It is therefore necessary to control temperature of the gas to be supplied to 80 ° C or lower. Thus, as described above, the gas (with temperature and humidity controlled) to be applied to the closed container 101 is temperature-regulated to 80 ° C or lower. The temperature may be controlled so as to fall within a range of, for example, 18°C to 32 ° C in order to further facilitate temperature regulation.

Although the objective electric elements are the capacitor and the diode in this embodiment because diodes and capacitors are more susceptible to temperature and humidity than other elements, the closed container 101 may include other electric elements. The number of the closed container 101 depends on the number of mass filters. For example, the number of the closed containers 101 is four for a quadrupole filter used as the mass filter, and the number is eight for an octupole filter used as the mass filter.

### Connection between Piping Unit 106 and Closed Container 101

Fig. 5 illustrates an exemplary structure (as viewed from directly above) of a connecting portion 1061 between each closed container 101 and a piping unit 106. As illustrated in Fig. 5, the closed container 101 has the guide unit (connecting portion) 1061 for connecting the piping unit (diffusion pipe) 106 and the closed container 101 to each other. The guide unit 1061 has a plurality of diaphragms (rectifying plates) 1062 to adjust flows (flow velocities) of the gas to be even. The diaphragms 1062 are arranged so as to form an angle and an opening area so that the gas uniformly flows (flows at uniform flow velocities) into the closed container (casing) 101. That is, since the guide portion 1061 is configured so as to gradually expand along the traveling direction of the gas, the flow velocity of the gas in the guide portion 1061 is larger in the central portion than in the outer peripheral portion of the guide portion 1061. As a result, the diaphragms 1062 are arranged in the guide unit 1061 such that outer opening area is larger than central opening area, thereby flow velocities of the gas flowing through the respective openings can be made even.

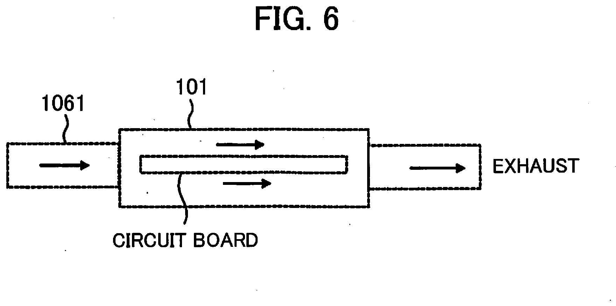

Fig. 6 illustrates an exemplary structure (cross section) of the connecting portion 1061 between the closed container 101 and the piping unit 106. As illustrated in Fig. 6, the gas supplied via the piping unit 106 and the connecting portion 1061 flows into the closed container (casing) 101, passes through the top and bottom sides of the circuit board (cools the top and bottom surfaces of the circuit board), and flows out of the closed container 101 to be exhausted.

### Summary

(i) According to this embodiment, the power supply control unit, which supplies power to the mass spectrometer, controls humidity and temperature (for example, to 80°C or lower, preferably to 18°C to 32°C) of the gas (e.g. nitrogen gas with a dew point temperature of -40°C and an extremely low humidity (e.g., 0.1%)), which is supplied from the gas supply unit, such that the gas has a dew point lower than that of the environment in which the circuit board having thereon the electric elements (for example, capacitor and diode) is located, and applies the gas with the humidity and temperature controlled to at least part of the circuit board. This makes it possible to prevent electrical characteristics of the electric elements from changing under the influence of environmental temperature and humidity. As a result, it is possible to solve the problems of drift of the mass axis, changes in signal intensity, and degradation of resolution in mass spectra.

The power supply control unit includes a mechanism for controlling humidity and temperature of the gas, the mechanism including: a part that controls the humidity and temperature of the gas by cooling or heating the gas; and the piping unit that guides the gas with the humidity and temperature controlled to the circuit board. The humidity/temperature measuring instrument is provided in the surrounding environment of the circuit board to measure humidity and temperature of the surrounding environment. This makes it possible to efficiently supply the gas with temperature and humidity controlled to the environment in which the circuit board is provided.

The mechanism includes: the humidity controller that, based on the measurement results of the humidity/temperature measuring instrument, calculates the dew point temperature T1 of the surrounding environment of the circuit board, and calculates humidity such that the dew point temperature T2 of the gas is lower than the dew point temperature T1; and the humidity regulator that regulates humidity of the gas supplied from the gas supply unit on the basis of the humidity calculated by the humidity controller. This makes it possible to appropriately regulate the temperature and the humidity of the gas to be supplied in consideration of the current state (environment) in which the circuit board is placed.

The circuit board and the humidity/temperature measuring instrument are housed in the closed container (having a heat-insulating structure), and the piping unit (having a heat-insulating structure) is connected at one end to a device controlling the humidity and temperature of the gas and at the other end to the closed container. The circuit board is provided in such environment, i.e., within the closed container, which secures stable control of humidity and temperature of the environment.

Further, the closed container has the inlet and the outlet for the gas, and has the guide unit (see Fig. 5) for uniformly applying the gas to the circuit board in the space between the inlet and the outlet. The piping unit is connected to the closed container via the guide unit. The guide unit has a shape of gradually expanding along the traveling direction and has diaphragms provided within the guide unit. The diaphragms partition the guide unit to form a plurality of openings and adjust gas flow to achieve even flow velocity at each opening. This allows uniform gas flow in the closed container, making it possible to evenly apply the gas to the electric elements mounted on the circuit board.

The device (gas cooling unit 105) controlling humidity and temperature of the gas at least includes a metal part having a ventilation channel guiding the gas supplied from the gas supply unit to the piping unit, and the Peltier element (Peltier cooling unit) provided in contact with the metal part. The temperature measuring unit, which measures temperature of the supplied gas, is provided in a portion (near the exit from the metal part) of the piping unit. The Peltier controller controls the amount of energizing current to the Peltier element based on the temperature of the gas notified from the temperature measuring unit. This makes it possible to readjust temperature of the gas to be supplied to the optimum temperature even if the temperature varies.

(ii) In this embodiment, control lines and information lines are those considered necessary for illustrative purposes and not necessarily all control and information lines for products. All components may be interconnected.

Other implementations of the disclosure will also be apparent to those having ordinary knowledge of the art from the specification of the disclosure disclosed herein and from the discussion of the embodiment. Various aspects and/or components of the embodiment described can be used singly or in any combination. The specification and examples are exemplary only, and the scope of the disclosure is indicated by the following claims.

### List of Reference Signs

1: mass spectrometric instrument, 10: power supply control unit, 20: mass spectrometer, 30: output unit, 201: ion source, 202: mass filter, 203: ion detector, 101: closed container, 102: gas supply unit, 103: humidity controller, 104: humidity regulator, 105: gas cooling unit, 106: piping unit, 107: Peltier controller, 108: temperature measuring unit, 1011: detector circuit, 1012: voltage-dividing circuit, 1013: humidity/temperature measuring instrument, 1051: metal plate, 1052: Peltier cooling unit (Peltier element), 1053: heat sink, 1054: cooling fan

## Claims

1. A mass spectrometric instrument, comprising:
a circuit board on which electric elements are disposed, the electric elements including a capacitor forming a voltage-dividing circuit (1012) and a diode forming a detector circuit, and used in an electric circuit that feeds back a high-frequency voltage supplied to a mass filter (202) of a mass spectrometer;
a casing that houses the circuit board;
a gas supply unit (102); and
a mechanism that controls humidity and temperature of gas supplied from the gas supply unit (102) and applies the gas with the humidity and temperature controlled to the capacitor and the diode,
wherein
the mechanism includes a piping unit (106) that guides the gas with the humidity and temperature controlled to the circuit board, and
a diaphragm for adjusting the gas is disposed at a connecting portion between the casing and the piping unit (106),
the mass spectrometric instrument further comprising:
a humidity/temperature measuring instrument (1013) that measures humidity and temperature of surrounding environment of the circuit board;
temperature measuring units provided on the detector circuit and on the voltage-dividing circuit (1012);
a humidity controller (103) that, on the basis of information on humidity from the humidity/temperature measuring instrument (1012) and information on temperature from the temperature measuring units on the detector circuit and the voltage-dividing circuit (1012), calculates dew point temperature T1 of the surrounding environment of the circuit board, and calculates humidity that allows dew point temperature T2 of the gas to be lower than the dew point temperature T1; and
a humidity regulator (104) that regulates humidity of the gas supplied from the gas supply unit (102) on the basis of the humidity calculated by the humidity controller (103).

2. The mass spectrometric instrument according to claim 1, wherein the connecting portion between the casing and the piping unit (106) corresponds to a guide unit configured so as to gradually expand along a travelling direction of the gas.

3. The mass spectrometric instrument according to claim 2, wherein the mechanism includes a device that controls the humidity and the temperature of the gas by cooling or heating the gas.

4. The mass spectrometric instrument according to claim 1, wherein
the circuit board and the humidity/temperature measuring instrument (1013) are housed in the casing, and
the piping unit (106) is connected at one end to a device controlling the humidity and the temperature of the gas, and at the other end to the casing.

5. The mass spectrometric instrument according to claim 4, wherein
the casing is insulated from heat, and
the piping unit (106) has a heat-insulating structure.

6. The mass spectrometric instrument according to claim 3, wherein the device controlling the humidity and the temperature of the gas in the mechanism at least includes: a metal part having a ventilation channel guiding the gas supplied from the gas supply unit (102) to the piping unit (106); and a Peltier element provided in contact with the metal part.

7. The mass spectrometric instrument according to claim 6, further comprising:
a temperature measuring unit (108) that measures temperature of the gas discharged from the metal part into the piping unit (106); and
a Peltier controller that controls the amount of energizing current to the Peltier element (1052) on the basis of the temperature of the gas notified from the temperature measuring unit (108).

8. The mass spectrometric instrument according to claim 2, wherein the gas supply unit (102) supplies nitrogen gas.

9. The mass spectrometric instrument according to claim 8, wherein the mechanism controls temperature of the nitrogen gas to 80°C or lower.

10. The mass spectrometric instrument according to claim 9, wherein the mechanism controls the temperature of the nitrogen gas to 18°C to 32°C.

## Patentansprüche

1. Massenspektrometrisches Instrument, umfassend:
eine Leiterplatte, auf der elektrische Elemente angeordnet sind, wobei die elektrischen Elemente einen Kondensator, der eine Spannungsteilerschaltung (1012) bildet, und eine Diode, die eine Detektorschaltung bildet, umfassen und in einer elektrischen Schaltung verwendet werden, die eine Hochfrequenzspannung rückkoppelt, die einem Massenfilter (202) eines Massenspektrometers zugeführt wird;
ein Gehäuse, das die Leiterplatte aufnimmt;
eine Gaszufuhreinheit (102); und
einen Mechanismus, der Feuchtigkeit und Temperatur von Gas, das von der Gaszufuhreinheit (102) zugeführt wird, steuert und das Gas mit der gesteuerten Feuchtigkeit und Temperatur an den Kondensator und die Diode anlegt,
wobei
der Mechanismus eine Rohrleitungseinheit (106) umfasst, die das Gas mit der gesteuerten Feuchtigkeit und Temperatur zu der Leiterplatte führt, und
eine Membran zum Einstellen des Gases an einem Verbindungsabschnitt zwischen dem Gehäuse und der Rohrleitungseinheit (106) angeordnet ist,
wobei das massenspektrometrische Instrument ferner umfasst:
ein Feuchtigkeits-/Temperaturmessinstrument (1013), das Feuchtigkeit und Temperatur der Umgebung der Leiterplatte misst;
Temperaturmesseinheiten, die auf der Detektorschaltung und auf der Spannungsteilerschaltung (1012) bereitgestellt sind;
eine Feuchtigkeitssteuerung (103), die auf der Grundlage von Informationen über Feuchtigkeit von dem Feuchtigkeits-/Temperaturmessinstrument (1012) und Informationen über Temperatur von den Temperaturmesseinheiten auf der Detektorschaltung und der Spannungsteilerschaltung (1012) eine Taupunkttemperatur T1 der Umgebung der Leiterplatte berechnet und Feuchtigkeit berechnet, die es ermöglicht, dass die Taupunkttemperatur T2 des Gases niedriger als die Taupunkttemperatur T1 ist; und
einen Feuchtigkeitsregler (104), der Feuchtigkeit des Gases, das von der Gaszufuhreinheit (102) zugeführt wird, auf der Grundlage der Feuchtigkeit, die durch die Feuchtigkeitssteuerung (103) berechnet wird, reguliert.

2. Massenspektrometrisches Instrument nach Anspruch 1, wobei der Verbindungsabschnitt zwischen dem Gehäuse und der Rohrleitungseinheit (106) einer Führungseinheit entspricht, die konfiguriert ist, um sich entlang einer Bewegungsrichtung des Gases allmählich auszudehnen.

3. Massenspektrometrisches Instrument nach Anspruch 2, wobei der Mechanismus eine Vorrichtung umfasst, die die Feuchtigkeit und die Temperatur des Gases durch Kühlen oder Erwärmen des Gases steuert.

4. Massenspektrometrisches Instrument nach Anspruch 1, wobei
die Leiterplatte und das Feuchtigkeits-/Temperaturmessinstrument (1013) in dem Gehäuse aufgenommen sind, und
die Rohrleitungseinheit (106) an einem Ende mit einer Vorrichtung, die die Feuchtigkeit und die Temperatur des Gases steuert, und an dem anderen Ende mit dem Gehäuse verbunden ist.

5. Massenspektrometrisches Instrument nach Anspruch 4, wobei
das Gehäuse gegen Wärme isoliert ist, und
die Rohrleitungseinheit (106) eine wärmeisolierende Struktur aufweist.

6. Massenspektrometrisches Instrument nach Anspruch 3, wobei die Vorrichtung, die die Feuchtigkeit und die Temperatur des Gases in dem Mechanismus steuert, mindestens Folgendes umfasst: ein Metallteil mit einem Belüftungskanal, der das Gas, das von der Gaszufuhreinheit (102) zugeführt wird, zu der Rohrleitungseinheit (106) führt; und ein Peltier-Element, das in Kontakt mit dem Metallteil bereitgestellt ist.

7. Massenspektrometrisches Instrument nach Anspruch 6, ferner umfassend:
eine Temperaturmesseinheit (108), die die Temperatur des Gases misst, das von dem Metallteil in die Rohrleitungseinheit (106) abgegeben wird; und
eine Peltier-Steuerung, die die Menge von Erregungsstrom zu dem Peltier-Element (1052) auf der Grundlage der Temperatur des Gases, die von der Temperaturmesseinheit (108) mitgeteilt wird, steuert.

8. Massenspektrometrisches Instrument nach Anspruch 2, wobei die Gaszufuhreinheit (102) Stickstoffgas zuführt.

9. Massenspektrometrisches Instrument nach Anspruch 8, wobei der Mechanismus die Temperatur des Stickstoffgases auf 80°C oder weniger steuert.

10. Massenspektrometrisches Instrument nach Anspruch 9, wobei der Mechanismus die Temperatur des Stickstoffgases auf 18°C bis 32°C steuert.

## Revendications

1. Instrument spectrométrique de masse, comprenant :
une carte de circuit sur laquelle sont disposés des éléments électriques, les éléments électriques comprenant un condensateur formant un circuit diviseur de tension (1012) et une diode formant un circuit détecteur, et utilisés dans un circuit électrique qui renvoie une tension haute fréquence fournie à un filtre de masse (202) d'un spectromètre de masse ;
un boîtier qui loge la carte de circuit ;
une unité d'alimentation en gaz (102) ; et
un mécanisme qui commande l'humidité et la température du gaz fourni par l'unité d'alimentation en gaz (102) et applique le gaz avec l'humidité et la température commandées au condensateur et à la diode,
dans lequel
le mécanisme comprend une unité de tuyauterie (106) qui guide le gaz avec l'humidité et la température commandées vers la carte de circuit, et
un diaphragme pour ajuster le gaz est disposé au niveau d'une partie de raccordement entre le boîtier et l'unité de tuyauterie (106),
l'instrument spectrométrique de masse comprenant en outre :
un instrument de mesure d'humidité/température (1013) qui mesure l'humidité et la température de l'environnement environnant de la carte de circuit ;
des unités de mesure de température prévues sur le circuit détecteur et sur le circuit diviseur de tension (1012) ;
un dispositif de commande d'humidité (103) qui, sur la base d'informations sur l'humidité provenant de l'instrument de mesure d'humidité/température (1012) et d'informations sur la température provenant des unités de mesure de température sur le circuit détecteur et le circuit diviseur de tension (1012), calcule la température de point de rosée T1 de l'environnement environnant de la carte de circuit, et calcule l'humidité qui permet à la température de point de rosée T2 du gaz d'être inférieure à la température de point de rosée T1 ; et
un régulateur d'humidité (104) qui régule l'humidité du gaz fourni par l'unité d'alimentation en gaz (102) sur la base de l'humidité calculée par le dispositif de commande d'humidité (103).

2. Instrument spectrométrique de masse selon la revendication 1, dans lequel la partie de raccordement entre le boîtier et l'unité de tuyauterie (106) correspond à une unité de guidage configurée de manière à se dilater progressivement le long d'une direction de déplacement du gaz.

3. Instrument spectrométrique de masse selon la revendication 2, dans lequel le mécanisme comprend un dispositif qui commande l'humidité et la température du gaz en refroidissant ou en chauffant le gaz.

4. Instrument spectrométrique de masse selon la revendication 1, dans lequel
la carte de circuit et l'instrument de mesure d'humidité/température (1013) sont logés dans le boîtier, et
l'unité de tuyauterie (106) est raccordée au niveau d'une extrémité à un dispositif commandant l'humidité et la température du gaz, et au niveau de l'autre extrémité au boîtier.

5. Instrument spectrométrique de masse selon la revendication 4, dans lequel
le boîtier est isolé de la chaleur, et
l'unité de tuyauterie (106) a une structure d'isolation thermique.

6. Instrument spectrométrique de masse selon la revendication 3, dans lequel le dispositif commandant l'humidité et la température du gaz dans le mécanisme comprend au moins : une partie métallique ayant un canal de ventilation guidant le gaz fourni par l'unité d'alimentation en gaz (102) vers l'unité de tuyauterie (106) ; et un élément Peltier prévu en contact avec la partie métallique.

7. Instrument spectrométrique de masse selon la revendication 6, comprenant en outre :
une unité de mesure de température (108) qui mesure la température du gaz déchargé de la partie métallique dans l'unité de tuyauterie (106) ; et
un dispositif de commande Peltier qui commande la quantité de courant d'excitation vers l'élément Peltier (1052) sur la base de la température du gaz notifiée par l'unité de mesure de température (108).

8. Instrument spectrométrique de masse selon la revendication 2, dans lequel l'unité d'alimentation en gaz (102) fournit de l'azote gazeux.

9. Instrument spectrométrique de masse selon la revendication 8, dans lequel le mécanisme commande la température de l'azote gazeux à 80 °C ou moins.

10. Instrument spectrométrique de masse selon la revendication 9, dans lequel le mécanisme commande la température de l'azote gazeux à 18 °C à 32 °C.
